(19) Europäisches Patentamt
European Patent Office
Office européen des brevets

(11) Publication number: 0 127 363 B1

(12) **EUROPEAN PATENT SPECIFICATION**

(45) Date of publication of patent specification: 27.07.88

(51) Int. Cl.$^4$: H 01 L 27/14

(21) Application number: 84303199.8

(22) Date of filing: 11.05.84

# (54) Image sensors.

(30) Priority: 24.05.83 GB 8314300

(43) Date of publication of application: 05.12.84 Bulletin 84/49

(45) Publication of the grant of the patent: 27.07.88 Bulletin 88/30

(84) Designated Contracting States: DE FR NL

(56) References cited: US-A-3 931 463

(73) Proprietor: The General Electric Company, p.l.c.
1 Stanhope Gate
London W1A 1EH (GB)

(72) Inventor: Bell, Raymond Thomas
4 Alton Avenue
Stanmore Middlesex (GB)
Inventor: Morcom, Christopher John
Navas House The Maultway
Camberley Surrey (GB)

(74) Representative: Pope, Michael Bertram Wingate
Central Patent Department Wembley Office The General Electric Company, p.l.c. Hirst Research Centre East Lane
Wembley Middlesex HA9 7PP (GB)

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).



Courier Press, Leamington Spa, England.

**Description**

This invention relates to image sensors, in particular to charge coupled device (CCD) frame transfer image sensors according to the prior art portion of claim 1. Such an image sensor is disclosed in US—A—3 931 463.

In CCD frame transfer image sensors, light representing an image is focussed onto a first photo-sensitive portion of an array of CCD channels comprising an image section of the array. A second portion of the array of CCD channels which is non photo-sensitive, e.g. due to being shielded from light, comprises a store section. Adjacent to the store section there is provided a line read-out section. A frame of charge photogenerated in the image section is transferred to the store section by applying clock pulses to the control electrodes of both sections, then read out in sequential line-by-line fashion by applying clock pulses to the control electrodes of both store and line read-out sections. Normally a frame of charge is read out of the store section as a further frame is being collected in the image section, and so on. Thus the 'integration period' during which a frame of photogenerated charge is collected in the image section of the sensor can not normally be shorter than the time takem to read out the previous frame of charge from the store section. The read out time is often fixed to conform to a given output standard, for example in conventional 525/625 line television, and is, in any case, limited by the physical constraints of the device structure, for example the speed of charge transfer. Then then precludes the use of the very short integration periods which may be a desirable feature in such applications as the imaging of fast moving objects, or in high illumination situations, unless a mechanical shutter, with all its attendant problems of mechanical unreliability, is employed in front of the sensor.

It is an object of the invention to provide CCD frame transfer image sensor wherein the effective integration period can be shortened by electrical means.

According to the present invention a CCD frame transfer image sensor comprises: an image section comprising a photo-sensitive portion of an array of CCD channels, a store section comprising a non photo-sensitive portion of said array of CCD channels; a line read-out section adjacent to the store section; a control electrode structure associated with said image, store, and read out sections; a charge sink structure; and means for generating and applying potentials to the control electrode structure so as to transfer charge generated in the image section along the channels into the store section, and to read out charge stored in said store section via said read-out section to provide an output signal, said means for generating and applying potentials being further arranged to control the potentials applied to the control electrode structure at a frequency outside the bandwidth of said output signals so as to transfer charge generated in the image section along the channels into the charge sink structure, thereby to control the period for which charge is collected in the image section before transfer to the store section.

In one particular sensor in accordance with the invention said charge sink structure is disposed at the end of said CCD channels remote from the store section of the sensor, the image section portion of the array of CCD channels and its associated electrodes are arranged so that charges may be transferred in either direction along said channels, and said means for controlling the potentials applied to the electrodes comprises means for controlling the potentials so as to transfer charge along the CCD channels in a direction towards or away from said sink structure.

Said charge sink structure is suitably a p-n junction.

One CCD frame transfer image sensor in accordance with the invention will now be described, by way of example only, with reference to the accompanying drawings in which:

Figure 1 shows a schematic diagram of the sensor;

Figure 2 shows a cross section along part of the length of one of the CCD channels of the image section of the sensor;

Figure 3(a) represents the read-out signal of the store section of the sensor;

Figure 3(b) represents the clocking signal applied to the CCD channels of the image section of a conventional sensor;

Figure 3(c) illustrates the general principle of reverse clocking; and

Figures 3(d) and 3(e) represent respectively first and second examples of the clocking signal applied to the CCD channels of the image section of the sensor in accordance with the invention.

Referring firstly to Figure 1, the sensor includes an array having five charge transfer CCD channels 1 arranged side by side. The array is fabricated in known manner on a silicon substrate, adjacent channels being isolated from each other by channel stop regions in the substrate, represented by dotted lines 3 in Figure 1. Charge storage elements within each channel 1 are defined by a three-phase electrode structure 5, 7, the storage elements within the channels being aligned to form rectangle array of charge storage elements. One half of the array, the upper half in Figure 1, is open to incoming light, and forms the image section 9 of the sensor, whilst the other half of the array, the lower half in Figure 1 is shielded from the light, and forms the store section 11 of the sensor. At one end of the store section 11, the lower end in Figure 1, there is a line read out section 13. The sensor also includes clock pulse generating means 18 effective to apply clock pulses to the electrode structure of the image, store and read-out sections.

In use an optical image is focussed onto the image section 9 of the sensor, and a charge pattern corresponding to the image is generated by the photo-electric effect in the storage elements underlying the image. In conventional sensors a frame of charge thus generated over a period of time, the integration period, in the charge storage elements of the image section 9, is, by application of clock pulses $IØ_1$, $IØ_2$, $IØ_3$ to the electrode structure 5 and clock pulses $SØ_1$, $SØ_2$ and $SØ_3$ to the electrode structure 7, transferred quickly to the store section 11. This is then read out sequentially line by line, through the line read-out section 13 by application of further clock pulses $SØ_1$, $SØ_2$, $SØ_3$, to the store section electrode structure 7. And $RØ_1$, $RØ_2$, $RØ_3$ to the read-out section electrode structure.

An output signal of the form shown in Figure 3(a) is thus obtained which includes periods of zero output known as line blanking periods, between the signals for successive lines during each of which a line of charge is transferred from the store section to the read-out section (read-out period), and periods of zero output, known as frame blanking periods, between the signals for successive frames, during each of which there occurs a period during which a frame of charge is transferred from the image section to the store section, i.e. a frame transfer period.

It will be understood that for each frame of charge the time available for charge generation, i.e. the integration period, is the period between successive frame transfer periods, as illustrated in Figure 3(b). In conventional CCD image sensors the integration period comprises substantially the whole of this available period.

Referring now also to Figure 2, the sensor further includes a charge sink structure comprising an appropriately doped layer forming a p-n junction at the end of the image section of the array further from the store section, adjacent to the end storage elements of the channels 1. Interposed on the surface of the substrate between an electrode 17 provided to the junction 15 and the first electrode of the electrode structure 5 is an additional electrode 19. In addition, the clock pulse generating means 18 is arranged so as to enable the electrode structure 5 of the image section to be clocked in reverse sequence during the conventional integration period as well as in the normal forward sequence during the frame transfer period. When the electrode structure is reverse clock, if the p-n junction 15 is held under sufficient reverse bias ($V_D$), charge photogenerated in the image section 9 will be transferred up the image section to be dumped in the sink formed by the junction 15, or when the reverse clocking stops, the effective integration period will then be the remainder of the conventional integration period before frame transfer to the store 11 takes place, as shown in Figure 3(c). Thus control of the effective integration time is achieved by choosing the time at which the reverse clocking stops. The electrode 19 is held at a fixed bias $V_G$ to isolate the sink from the CCD when charge dumping is not required.

Whilst the reverse clocking sequence described hereinbefore illustrates the general principle of the reverse clocking, implementing reverse clocking in this way can lead to practical problems. If the frequency of the reverse clocking is within the output bandwidth of the sensor, then spurious patterning of the output signal is almost unavoidable through parasitic pickup of the reverse clocking waveform in the output signal. A way of overcoming the problem is shown in Figure 3(d) in which the reverse clocking takes place at a frequency outside the output signal bandwidth, with sufficient pulses to sweep all the charge out of the image section 9 to the sink. The reverse clocking will occur just before the start of the integration period, but it may be necessary also to apply reverse clocking at earlier times as well, as indicated within the dotted lines in Figures 3(d), in order to prevent a build-up of charge in the image section 9 which can not be cleared by the single application of reverse clocking. Although clocking at a high frequency can cause problems with excessive power dissipation, since the power dissipation of the electronic circuitry generating the clock pulses is proportional to frequency, reverse clocking will be relatively infrequent so that this extra power dissipation will be minimised. A further possibility is to combine the clock pulse sequences described herebefore in relation to Figure 3(d) with a sequence in which reverse clocking pulses are applied during the line blanking periods. This is shown in Figure 3(e).

It will be appreciated that whilst the sensor described herebefore has only five charge transfer channels 1, and a limited number of elements for the sake of clarity, a practical sensor, for example as used in a 625-line TV compatible camera would have an array of 385×576 elements. In such a sensor, a variation of integration period of 20 ms to less than 1 ms has been demonstrated.

If suitable circuitry such as that indicated as 20 in Figure 1 is used to sense the mean or peak level of the output signal of the sensor and a control loop set up to control the time at which reverse clocking of the image sections steps, and hence the integration period on a continuous basis to keep the output at a fixed mean level, what is described on film cameras as automatic exposure control may be achieved.

It is a particular feature of a sensor in accordance with the invention that control of the integration period is obtained without significant reduction in the fraction of the area of the image section which is available for charge collection.

**Claims**

1. A CCD frame transfer image sensor comprising: an image section (9) comprising a photosensitive portion of an array (1) of CCD channels; a store section (11) comprising a non photosensitive portion of said array (1) of CCD channels; a line read-out section (13) adjacent to the store section; a control electrode (5, 7) structure associated with said image (9), store (11), and read-out (13) sections; means for generating and applying potentials (18) to the control electrode structure so as to transfer charge generated in the image section (9) along the channels into the store section (11), and to read out charge stored in said store section (11), via said read-out section (13), a charge sink structure (15), said means for generating and applying potentials (18) being further arranged to control the potentials applied to the control electrode structure so as to transfer charge generated in the image section (9) along the channels into the charge sink structure (15), thereby to control the period for which charge is collected in the image section before transfer to the store section said sensor being characterised in that said means generating and for applying potentials is arranged to apply said potentials effective to transfer charge into the sink structure (15) at a frequency outside the bandwidth of the output signal of the sensor.

2. A sensor according to Claim 1 in which said charge sink structure (15) is disposed at the end of said CCD channels remote from the store section (11) of the sensor, the image section (9) portion of the array (1) of CCD channels and its associated electrodes (5) are arranged so that charges may be transferred in either direction along said channels, and said means (18) for controlling the potentials applied to the electrodes (5) comprises means for controlling the potentials so as to transfer charge along the CCD channels in a direction towards or away from said sink structure (15).

3. A sensor according to either one of the preceding Claims in which said charge sink structure (15) is a p-n junction.

4. A sensor according to anyone of the preceding Claims in which said potentials applied to transfer said charge into said charge sink structure (15) are applied during at least one period of read-out of charge via said read-out section.

5. A sensor according to Claim 4 in which said potentials applied to transfer said charge into said charge sink structure (15), are also applied during line blanking periods.

6. A sensor according to any one of the preceding Claims in which said means (18) for controlling the potentials includes means for controlling the periods for which said potentials are applied to transfer charge into said charge sink structure (15) thereby to vary the effective charge integration time.

7. A sensor according to Claim 6 wherein said means for controlling said period comprises means (20) for sensing the level of the output signal of the sensor and means for controlling said periods in dependence on the level of said output signal, thereby to tend to maintain said level substantially constant.

**Patentansprüche**

1. CCD-Bildübertragungs-Bildsensor mit einem Bildabschnitt (9), der einen lichttempfindlichen Teil einer Anordnung (1) aus CCD-Kanälen aufweist (CCD=Ladungsverschiebungselement); einem Speicherabschnitt (11) mit einem lichtunempfindlichen Teil der erwähnten Anordnung (1) aus CCD-Kanälen; einem Zeilenausleseabschnitt (13) neben dem Speicherabschnitt; einer Steuerelektrodenanordnung (5, 7), die dem erwähnten Bildabschnitt (9), Speicherabschnitt (11) und Ausleseabschnitt (13) zugeordnet ist; einem Mittel zum Erzeugen und Anlegen von Potentialen (18) an die Steuerelektrodenanordnung, so daß in dem Bildabschnitt (9) erzeugte Ladungen längs der Kanäle in den Speicherabschnitt (11) übertragen und in dem erwähnten Speicherabschnitt (11) gespeicherte Ladungen ausgelesen werden, und zwar über den erwähnten Ausleseabschnitt (13), und einer Ladungssenkenanordnung (15), wobei das erwähnte Mittel zum Erzeugen und Anlegen von Potentialen (18) ferner so ausgebildet ist, daß es die an die Steuerelektrodenanordnung angelegten Potentiale so steuert, daß in dem Bildabschnitt (9) erzeugte Ladungen längs der Kanäle in die Ladungssenkenanordnung (15) übertragen werden, so daß dadurch die Zeitspanne gesteuert wird, während der Ladung in dem Bildabschnitt gesammelt wird, bevor sie in den Speicherabschnitt übertragen wird, dadurch gekennzeichnet, daß das erwähnte Mittel zum Erzeugen und Anlegen von Potentialen so ausgebildet ist, daß es die erwähnten Potentiale effektiv zur Übertragung der Ladung in die Senkenanordnung (15) mit einer Frequenz, die außerhalb der Bandbreite der Ausgangssignals des Sensors liegt, anlegt.

2. Sensor nach Anspruch 1, bei dem die Ladungssenkenanordnung (15) an dem von dem Speicherabschnitt (11) des Sensors entfernt liegenden Ende der erwähnten CCD-Kanäle angeordnet ist, der Bildabschnitt (9) der Anordnung (1) aus CCD-Kanälen und seine zugeordneten Elektroden (5) so ausgebildet sind, daß Ladungen in beiden Richtungen längs der erwähnten Kanäle übertragen werden können, und das erwähnte Mittel (18) zum Steuern der Potentiale, die an die Elektroden (5) angelegt werden, ein Mittel aufweist, durch das die Potentiale derart steuerbar sind, daß die Ladungen längs der CCD-Kanäle in Richtung zu der erwähnten Ladungssenkenanordnung (15) hin oder von dieser weg übertragungen werden.

3. Sensor nach irgendeinem der vorstehenden Ansprüche, bei dem die erwähnte Ladungssenkenanordnung (15) ein p-n-Übergang ist.

4. Sensor nach irgendeinem der vorstehenden Ansprüche, bei dem die erwähnten Potentiale, die zur Übertragung der erwähnten Ladung in die erwähnte Ladungssenkenanordnung (15) angelegt werden, während wenigstens einer Periode des Auslesens von Ladung über den erwähnten Ausleseabschnitt angelegt werden.

5. Sensor nach Anspruch 4, bei dem die erwähnten Potentiale, die zur Übertragung der erwähnten Ladung in die erwähnte Ladungssenkenanordnung (15) angelegt werden, auch während Zeilenaustastperioden angelegt werden.

6. Sensor nach irgendeinem der vorstehenden Ansprüche, bei dem das erwähnte Mittel (18) zum Steuern der Potentiale ein Mittel zum Steuern der Perioden, in denen die erwähnten Potentiale zur Übertragung von Ladungen in die erwähnte Ladungssenkenanordnung (15) angelegt werden, enthält, so daß die effektive Ladungsintegrationszeit geändert wird.

7. Sensor nach Anspruch 6, bei dem das erwähnte Mittel zum Steuern der erwähnten Periode ein Mittel (20) zum Feststellen des Pegels des Ausgangssignals des Sensors und ein Mittel zum Steuern der erwähnten Perioden in Abhängigkeit von dem Pegel des erwähnten Ausgangssignals aufweist, um dadurch den erwähnten Pegel weitgehend konstant zu halten.

**Revendications**

1. Capteur d'images à transfert de trame CCD, comprenant une section d'image (9) comprenant une partie photosensible d'un arrangement (1) de canaux CCD, une section (11) de mémoire comprenant une partie non photosensible de l'arrangement (1) de canaux CCD, une section (13) de lecture de lignes adjacente à la section de mémoire, une structure à électrodes (5, 7) de commande associée aux sections d'image (9), de mémoire (11) et de lecture (13), un dispositif destiné à créer et à appliquer des potentiels (18) à la structure à électrodes de commande afin que des charges créées dans la section (9) d'image soient transférées le long des canaux dans la section (11) de mémoire et que des charges conservées dans la section (11) de mémoire soient lues, par l'intermédiaire de la section (13) de lecture, une structure (15) d'absorption de charges, le dispositif destiné à créer et à appliquer des potentiels (18) étant en outre réalisé de manière qu'il règle les potentiels appliqués à la structure à électrodes de commande afin que les charges créées dans la section d'images (9) soient transférées le long des canaux dans la structure (15) d'absorption de charges, si bien que la période pendant laquelle les charges sont collectées dans la section d'image avant transfert à la section de mémoire est réglée, le capteur étant caractérisé en ce que le dispositif destiné à créer et à appliquer des potientiels est destiné à appliquer les potentiels afin qu'il transfère efficacement des charges à la structure (15) d'absorption à une fréquence qui se trouve en-dehors de la largeur de bande du signal de sortie du capteur.

2. Capteur selon la revendication 1, dans lequel la structure (15) d'absorption de charges est disposée à l'extrémité des canaux CCD qui est éloignée de la section (11) de mémoire du capteur, la partie de section (9) d'image de l'arrangement (1) des canaux CCD et ses électrodes associées (5) sont disposés de manière que des charges puissent être transférées dans les deux sens le long de canaux, et le dispositif (18) de réglage des potentiels appliqués aux électrodes (5) comporte un dispositif destiné à régler les potentiels de manière que des charges soient transférées le long des canaux CCD vers la structure d'absorption (15) ou en sens opposé.

3. Capteur selon l'une quelconque des revendications précédentes, dans lequel la structure (15) d'absorption de charges est une jonction p-n.

4. Capteur selon l'une quelconque des revendications précédentes, dans lequel les potentiels appliqués pour le transfert de charges à la structure (15) d'absorption de charges sont appliqués pendant au moins une période de lecture de charges par l'intermédiaire de la section de lecture.

5. Capteur selon la revendication 4, dans lequel les potentiels appliqués pour le transfert des charges dans la structure (15) d'absorption de charges sont aussi appliquées pendant des périodes de suppression de ligne.

6. Capteur selon l'une quelconque des revendications précédentes, dans lequel le dispositif (18) destiné à régler les potentiels comporte un dispositif de réglage des périodes pendant lesquelles les potentiels sont appliqués afin que les charges soient transférées à la structure (15) d'absorption de charges, afin que le temps efficace d'intégration de charges varie.

7. Capteur selon la revendication 6, dans lequel le dispositif de réglage de la période comporte un dispositif (20) destiné à détecter le niveau du signal de sortie du capteur, et un dispositif de réglage des périodes en fonction du niveau du signal de sortie, si bien que ce niveau a tendance à être maintenu à une valeur sensiblement constante.

Fig.1.

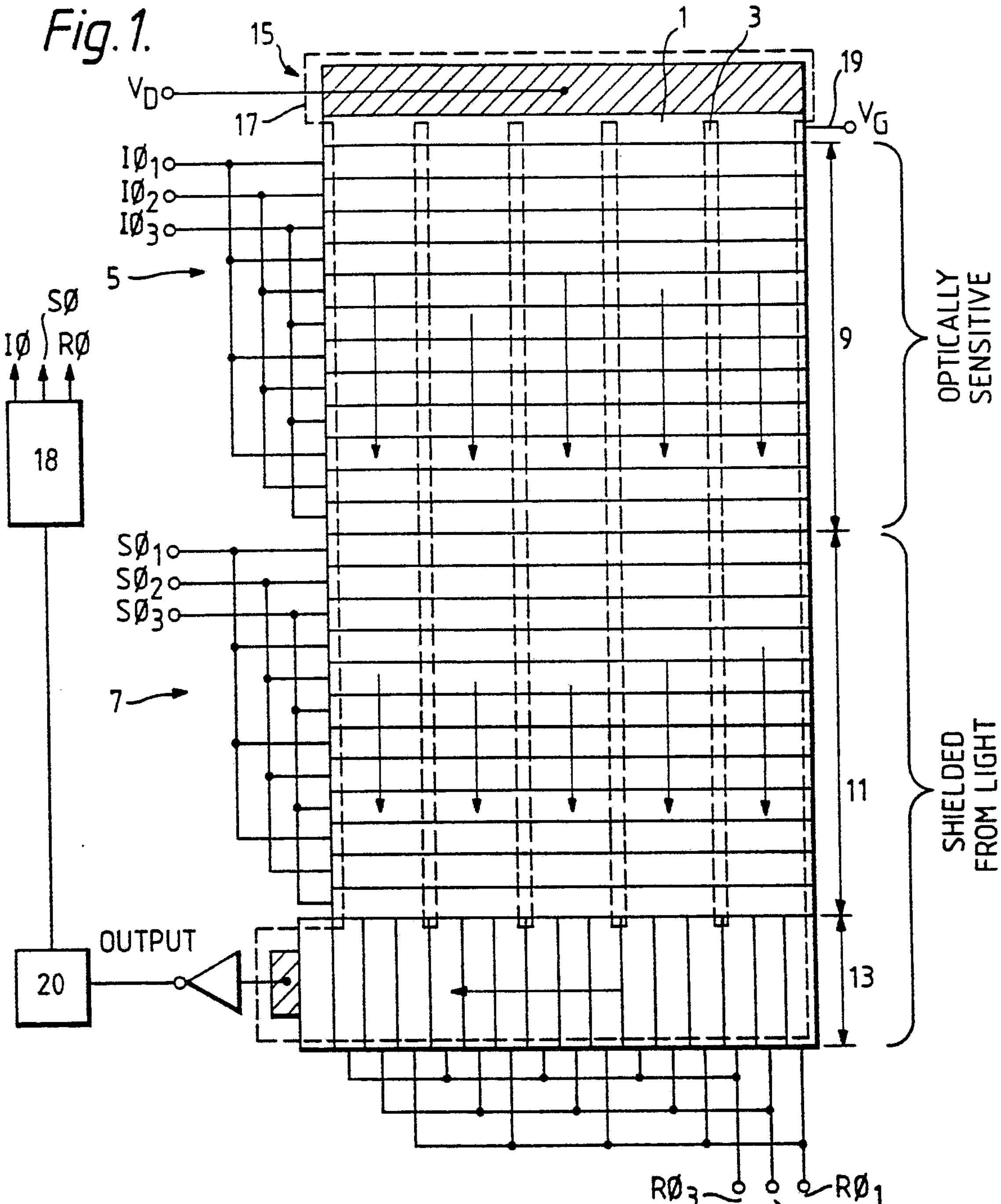
15
1
3
19
$V_D$
$V_G$
17
$I\phi_1$
$I\phi_2$
$I\phi_3$
5
$S\phi$
$I\phi$
$R\phi$
18
9
OPTICALLY SENSITIVE
$S\phi_1$
$S\phi_2$
$S\phi_3$
7
11
SHIELDED FROM LIGHT
OUTPUT
20
13
$R\phi_3$
$R\phi_2$
$R\phi_1$

Fig.2.

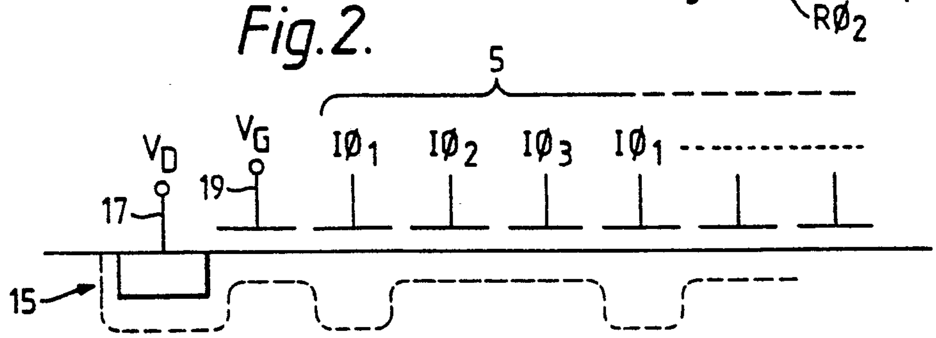
5
$V_D$
$V_G$
$I\phi_1$
$I\phi_2$
$I\phi_3$
$I\phi_1$
17
19
15

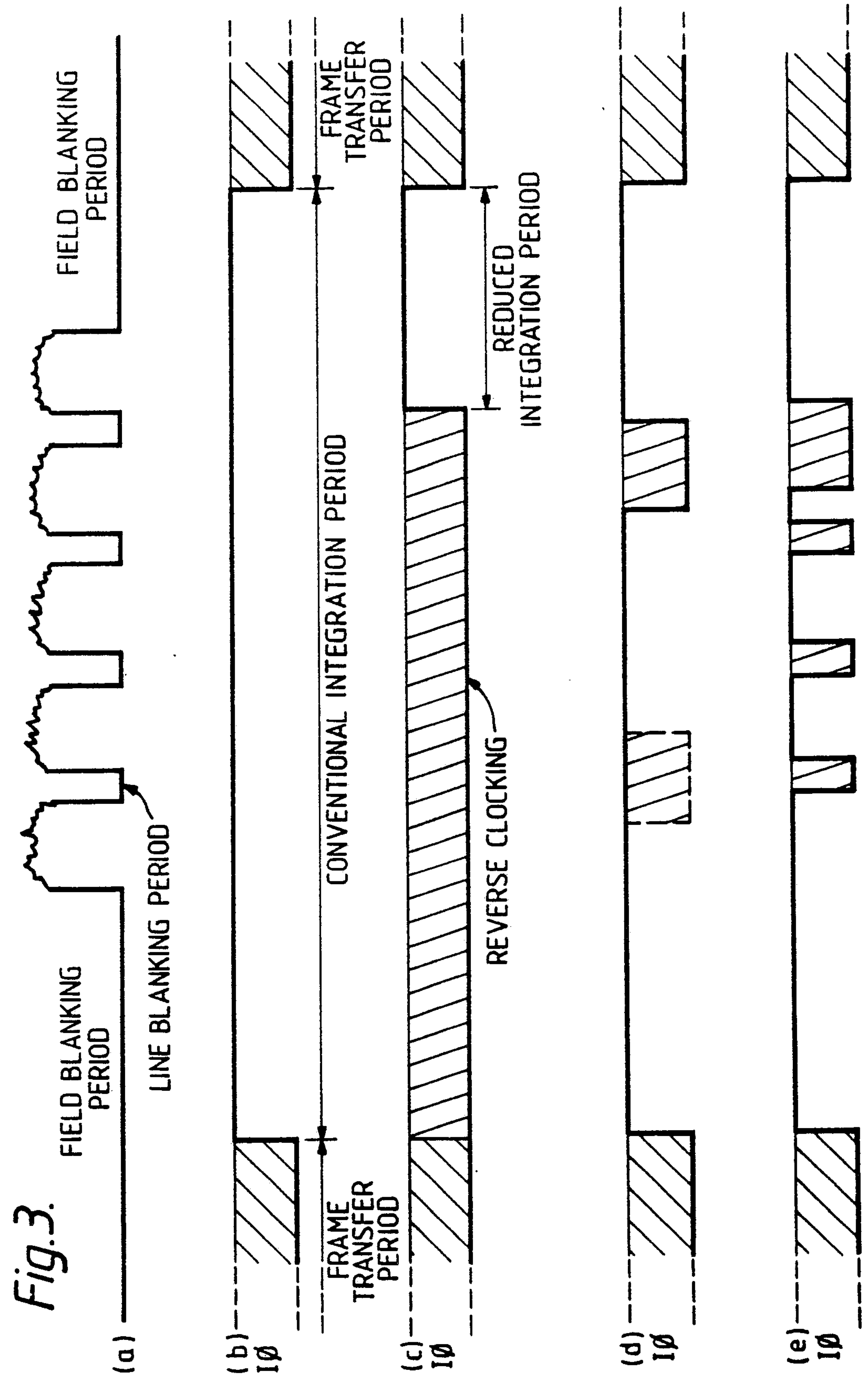
FIELD BLANKING PERIOD
LINE BLANKING PERIOD
FIELD BLANKING PERIOD
FRAME TRANSFER PERIOD
CONVENTIONAL INTEGRATION PERIOD
FRAME TRANSFER PERIOD
REVERSE CLOCKING
REDUCED INTEGRATION PERIOD
(a)
(b) IØ
(c) IØ
(d) IØ
(e) IØ

Fig.3.